# EUROPEAN PATENT APPLICATION

(11) **EP 4 800 989 A1**
(43) Date of publication of application: **02.09.2026**
(21) Application number: 25161007.7
(22) Date of filing: 28.02.2025
(51) Int. Cl.: H04L 27/18, H03D 1/00, H04L 27/26, H04L 27/34, H04L 27/38

(54) **COHERENT BPSK DEMODULATOR AND METHOD OF DEMODULATING A SIGNAL**

(71) Applicant: EM Microelectronic-Marin SA, 2074 Marin (CH)
(72) Inventor: BALTOLU, Anthony, 06200 Nice (FR); GHARIBDOUST, Kiarash, 1027 Lonay (CH); HORMATI, Ali, 1023 Crissier (CH)
(74) Representative: ICB SA

(57) **Abstract**

In one aspect the present invention concerns a coherent BPSK demodulator (10) for demodulating an input signal, the demodulator (10) comprising:
- an analog signal input (20) to provide an oscillating modulated input signal,
- a phase locked loop (12) comprising a phase detector (22), a loop filter (23), a voltage-controlled oscillator (24) and a frequency divider (25), which are connected in series, wherein in a first startup phase of the demodulator (10) the loop filter (23) is configured to become pre-charged in accordance with trimming values obtainable from a digital memory (37),
- a frequency estimator (34), which during a second startup phase of the demodulator (10) is operable to determine a frequency offset between a frequency of the input signal and a startup frequency of the voltage controlled oscillator (24), wherein the startup frequency is defined by the trimming values, and which is further operable to adjust the trimming values and the startup frequency to reduce the frequency offset.

## Description

### Field of the invention

The present invention relates to the field of Binary Phase Shift Keying (BPSK) demodulators and methods of using such demodulators for signal demodulation.

### Background

Binary Phase Shift Keying (BPSK) demodulators can be categorized in two main families: coherent demodulation and non-coherent demodulation. A coherent demodulator extracts a clock synchronized with the incoming signal and uses that clock for the demodulation process, mixing it with the incoming signal to get the modulated signal back in baseband. A non-coherent demodulator does not need to recreate a synchronized clock, it directly processes the incoming signal and finds the phase changes by means of oversampling and logic recognition.

BPSK demodulators used in mobile wireless receivers are generally placed after a gain chain and they should have a proper sensitivity to extract the received telegram or data from the carrier with a minimum required signal-to-noise ratio (SNR) for a target bit error-rate (BER). This function should be performed with a minimum possible energy consumption for longer battery lifetime. Having good sensitivity with minimum required SNR is essential for reducing power consumption as it simplifies the noise requirement on the gain chain and then on the overall system consumption, improving greatly the battery lifetime.

That is generally why a coherent demodulator is used in such systems, as it necessitates a lower SNR to reach the specified BER compared to a non-coherent one. Non-coherent demodulators, depending on the oversampling factor used, either have a too large energy consumption or require a too large SNR to meet the specified BER, and being thus unsuitable for low-power applications despite of their simplicity.

In ultra-low power BPSK receivers, one popular strategy to further reduce the consumption is to switch off the demodulator, leaving only the gain chain active in listening mode and once energy is detected, switch on the demodulator. This creates another constrain for the coherent BPSK receiver, which is a fast startup requirement so that the time from turning-on the demodulator to the time it extracts the clock from the incoming signal and locks to its frequency and its phase becomes compatible with wireless communication protocol.

Hence, the time allowed to train the receiver gain chain and the demodulator is specified by the communication protocol and tends to be reduced in modern protocols to have a lower communication latency. Solutions known from the prior art so far cannot address the fast startup and fast locking time for wireless communication protocols, which require stringent SNR and low power consumption.

It is therefore desirable to provide a fast startup and locking coherent BPSK demodulator, which is operable to compensate temperature deviations and to satisfy minimum SNR requirements. The BPSK modulator should have a minimum energy consumption and should be robust and failure safe. It should be implementable and/or manufacturable at low or moderate costs and should require only a minimum of geometric space.

### Summary of the invention

In one aspect there is provided a coherent BPSK demodulator. The BPSK demodulator comprises an analog signal input to provide an oscillating modulated input signal. Typically, the input signal is BPSK modulated. The coherent BPSK demodulator further comprises a phase locked loop. The phase locked loop comprises a phase detector, a loop filter, a voltage-controlled oscillator and a frequency divider. The phase detector, loop filter, the voltage-controlled oscillator and the frequency divider are connected in series to set up the phase locked loop. In some examples, an output of the phase detector is connected to an input of the loop filter. An output of the loop filter is connected with an input of the voltage-controlled oscillator. An output of the voltage-controlled oscillator is connected to an input of the frequency divider. An output of the frequency divider is connected back to one of the inputs of the phase detector to close the loop. The phase detector may be implemented as a digital phase detector, in such case the analog input signal may be squared into a pseudo digital signal level to connect one of the digital phase detector inputs. It may be provided with a clock input, which is connected or coupled to an in-phase clock output of the frequency divider of the phase locked loop.

The frequency divider may further comprise a clock output, e.g., implemented as a quadrature clock output to provide a sampling of the input signal.

During a start-up procedure, the coherent BPSK demodulator may be operable in one or two or three start phases. In a first startup phase of the demodulator the loop filter is configured to become pre-charged in accordance with trimming values that are obtainable from a digital memory. The trimming values may define a bias voltage for the voltage-controlled oscillator, which correlates with a predefined startup frequency of the voltage-controlled oscillator.

The trimming values may be obtainable from a non-volatile memory. They may be defined or determined during a final stage of production or testing of the coherent BPSK demodulator. The trimming values may define a target frequency for the voltage-controlled oscillator at room temperature.

The coherent BPSK demodulator further comprises a frequency estimator, e.g., implemented as a digital frequency estimator. During a second startup phase of the demodulator the frequency estimator is operable to determine a frequency offset between a frequency of the input signal and the predefined startup frequency of the voltage-controlled oscillator, which is defined by the trimming values.

The frequency estimator is further operable to adjust the trimming values and hence the startup frequency to reduce the frequency offset between the startup frequency and the frequency of the input signal. In this way the frequency estimator is configured to adapt the startup frequency and to reduce the frequency offset between the startup frequency and the frequency of the input signal, which might be due to temperature effects and/or due to a temperature difference from room temperature.

In this way the coherent BPSK demodulator can be promptly adapted to varying temperatures and specifically to temperature variations from room temperature.

By pre-charging the loop filter on the basis of the trimming values obtainable from a digital memory, the voltage-controlled oscillator may start oscillating at the startup frequency, which is fairly close to the incoming carrier frequency of the analog input signal. A residual frequency offset may be only due to the temperature difference or temperature offset from room temperature. By way of the frequency estimator, this remaining residual frequency offset can be reduced or even completely annihilated.

In this way and by reducing or by canceling the frequency offset between the startup frequency and the carrier frequency of the input signal a so-called cycle slipping effect during startup of the coherent BPSK demodulator can be effectively avoided or suppressed.

Otherwise, and with a comparatively large frequency variation between the oscillation frequency of the voltage-controlled oscillator and the carrier frequency of the incoming input signal a cycle slipping may become dominant and may disable or severely affect the startup of the BPSK demodulation.

With the frequency estimator and by adjusting the startup frequency such a cycle slipping effect can be suppressed and/or avoided thus enabling a rather fast and reliable startup of the coherent BPSK demodulator.

According to a further example, the BPSK demodulator further comprises a digital controller, which is operable to phase-lock the voltage-controlled oscillator on the input signal in a third startup phase of the demodulator after adjustment of the startup frequency. The third startup phase may define a steady state configuration of the demodulator, in which the modulator has passed a start-up routine and during which the demodulator is effectively demodulating the input signal.

Accordingly, and during the second phase of demodulator startup the voltage-controlled oscillator is let free running while the digitally implemented frequency estimator determines the frequency offset and aims to cancel a remaining frequency variation. Once the frequency offset has been reduced to a desired level the phase locked loop of the coherent BPSK demodulator is closed and the voltage-controlled oscillator is locked on the carrier frequency and phase of the input signal (third startup phase).

According to some examples and during the first startup phase the voltage-controlled oscillator is kept in an idle state, in which it does not oscillate while a bias is propagated to make the voltage-controlled oscillator ready for operation, e.g., during the subsequent second and third startup phases.

Accordingly, and in a further example the voltage-controlled oscillator is configured to oscillate freely during the second startup phase of the demodulator. Moreover and during the second startup phase of the demodulator the phase locked loop is unlocked. This allows for an update of the trimming values and an adjustment or fine-tuning of the startup frequency for the purpose of reducing a frequency offset with respect to the carrier frequency of the input signal.

According to a further example the BPSK demodulator further comprises a saturating amplifier. The saturating amplifier may be located or arranged between the analog signal input and the phase locked loop.

Accordingly, the phase locked loop may be provided with an output of the saturating amplifier. The saturating amplifier may be implemented as a squaring amplifier. The output of the squaring amplifier may represent a quasi-digital signal. This makes the phase locked loop working with digital levels thus enabling the use of a low-power digital phase detector in the phase locked loop.

Accordingly, and with a further example the phase locked loop comprises a digital phase detector coupled to an input of the loop filter. Typically, the digital phase detector is an initial or input component of the phase locked loop. The digital phase detector may comprise an input that is connected to an output of the saturating amplifier. An output of the digital phase detector may be connected or coupled to an input of the loop filter of the phase locked loop.

According to some examples, the digital phase detector may be employed as a Hogge phase detector or Hogge-type phase detector or it may be implemented as a phase detector equivalent to the Hogge-type phase detector. Using a digital level phase detector brings particular benefits for the phase locked loop. The loop drive becomes independent of the input signal amplitude. It may depend only on the phase difference between the incoming signal and the loop output.

Moreover, the digital phase detector, specifically when implemented as a Hogge- or Hogge-type phase detector, may be insensitive on phase jumps of the input signal, which are present in the BPSK modulated signal. Moreover, the phase difference detection range may cover the full phase cycle (from - π to +π). These advantages enlarge and speed up the captured range making the loop to lock faster than conventional demodulators, e.g. compared to Costas loop type demodulators.

According to a further example the frequency divider of the phase locked loop comprises an in-phase clock output, which is coupled to a clock input of the phase detector. The coupling of the in-phase clock output of the frequency divider with the clock input of the phase detector may close the phase locked loop.

According to a further example the BPSK modulator comprises a sampling flip-flop, which is connected to the analog signal input and which is triggered by a quadrature clock output of the frequency divider of the phase locked loop.

According to a further example the sampling flip-flop comprises a sampling input, which is connected to an output of the saturating amplifier. Hence, the sampling flip-flop may be implemented as a rather simple D flip-flop, which is triggered or sampled by the quadrature clock output of the frequency divider of the phase locked loop. The sampling flip-flop may be further connected or coupled to the output of the saturating amplifier or squaring amplifier and may thus receive the input signal as a quasi-digital input signal.

According to some examples the voltage-controlled oscillator of the phase locked loop may operate at two times or four times the carrier frequency of the input signal. This allows the frequency divider to create the in-phase clock signal and the quadrature clock signal, respectively. While the in-phase clock signal is used to close the phase locked loop the quadrature clock signal is used to sample the input signal at the amplitude peaks, where the signal-to-noise ratio is at a maximum.

By way of the saturating amplifier the analog input signal can be transferred into a quasi-digital signal, i.e. a digital signal that has its edges aligned with the zero crossings of the analog input signal. The middle of the half periods of the amplified input signal may be thus aligned with the peaks of the sinewave of the input signal. Once the phase locked loop is locked, the in-phase clock has its edges aligned with the sinewave zero crossings while the quadrature clock output is synchronized with the input signal peaks. This is the moment for which the incoming signal energy reaches its maximum amplitude, hence, it has the maximum signal-to-noise ratio for the demodulation. In this way, the bit error rate as well as the signal-to-noise ratio of the demodulated signal can be improved.

In another aspect the present disclosure also relates to a method of demodulating a BPSK modulated signal. The method is typically conducted by a coherent BPSK demodulator as described above. Insofar, all features, effects and benefits as described above in connection with the coherent BPSK demodulator may equally apply to the method of demodulating a BPSK modulated signal; and vice versa.

In some examples the method comprises the steps of using a BPSK demodulator as described above. The method further includes the step of pre-charging the loop filter of the phase locked loop on the basis of trimming values that are obtainable from a digital memory, typically, from a non-volatile digital memory during a first startup phase of the demodulator.

Thereafter and in a further step there is derived a startup frequency of the voltage-controlled oscillator of the phase locked loop on the basis of the trimming values. In a further step a frequency offset is determined between a frequency of the input signal and the startup frequency as defined or obtained on the basis of the trimming values. Finally, and in another step, e.g. during a second startup phase, the trimming values and the startup frequency are adjusted to reduce the frequency offset of the oscillator.

According to a further example and when in the second startup phase the voltage-controlled oscillator is configured to oscillate freely such as to allow and enable a frequency adjustment and an update of the trimming values.

During the first startup phase the voltage-controlled oscillator of the phase locked loop is kept in an idle state. It does not oscillate while a bias is propagated to make the voltage-controlled oscillator ready for operation. For instance and by way of the digital controller, the BPSK demodulator may be switched from the first startup phase to the second startup phase and further into the third startup phase, the latter of which may also represent a final or regular phase of operation.

During the second startup phase the voltage-controlled oscillator is led to oscillate freely for a predefined time interval while the frequency estimator, e.g., implemented as a digital assistant logic circuit provides an estimation of the frequency of the voltage-controlled oscillator. Here, the startup frequency of the voltage-controlled oscillator is adjusted to reduce or to annihilate any remaining frequency offset compared to the carrier frequency of the analog input signal.

Once the startup frequency of the voltage controlled oscillator has been properly adjusted during the second startup phase, the BPSK demodulator is switched into the third startup phase, in which the phase locked loop is closed and in which the voltage controlled oscillator of the phase locked loop is locked to the phase and frequency of the input signal.

According to a further example and after adjustment of the startup frequency and when in the third startup phase, the voltage-controlled oscillator is locked on the input signal and the phase locked loop is closed. The BPSK demodulator may then rather promptly operate on the carrier frequency of the input signal without any cycle slipping effect compared to the carrier wave of the input signal.

In a further example, the voltage-controlled oscillator is free running for a predefined time interval during the second startup phase of the demodulator. This allows the frequency estimator and hence the digital assistant logic circuit to provide an estimation of the frequency offset and to adjust the startup frequency of the voltage-controlled oscillator when locked in the proceeding third startup phase, in which the phase locked loop is closed.

According to a further example of the method of demodulating the BPSK modulated signal the phase locked loop is driven or closed by an in-phase clock output of the frequency divider of the phase locked loop. Since the startup frequency of the voltage-controlled oscillator and hence the frequency of the phase locked loop is appropriately adjusted and tuned to the frequency of the carrier wave of the input signal, the phase locked loop may not become subject to cycle slipping when closed and when in operation.

According to a further example the input signal is squarely amplified and provided to a sampling flip-flop. By way of a saturating amplifier or squaring amplifier the alternating analog signal can be transferred into a quasi-digital signal and/or into a respective square wave. This makes the entire BPSK demodulator and the phase locked loop working with digital levels, thus enabling the use of a low-power digital phase detector in the phase locked loop. Accordingly, the loop drive may become independent of the input signal amplitude and may only depend on the phase of the input signal. Moreover, the phase difference detection range may cover the full phase cycle. This may enlarge and speed up the capture range making the phase locked loop to lock faster compared to conventional demodulators, e.g. based on the Costas loop design.

Moreover, and according to another example the sampling flip-flop is clocked by a quadrature clock output of the frequency divider of the phase locked loop. The voltage-controlled oscillator of the phase locked loop may operate at a multiple integer of the carrier frequency. It may operate at two times or four times the carrier frequency, which allows the frequency divider to create the in-phase clock output and the quadrature clock output, respectively.

The in-phase clock output may be used to close the phase locked loop and the quadrature clock output of the frequency divider can be used to sample the input signals at the peaks, where the signal-to-noise ratio is at a maximum.

### Brief description of the drawings

In the following numerous examples of the invention will be described in greater detail by making reference to the drawings, in which:
- Fig. 1 is a block diagram of an example of the coherent BPSK demodulator,
- Fig. 2 is a block diagram of the internal implementation of the voltage-controlled oscillator of the phase locked loop of the - coherent BPSK demodulator,
- Fig. 3 is a signal diagram illustrating the individual signals during the various stages of demodulator startup,
- Fig. 4 is a further signal diagram of the loop filter voltage,
- Fig. 5 shows a further diagram with numerous signals for and during demodulation of the input signal, and
- Fig. 6 is a flowchart of a method of demodulating the BPSK modulated signal in accordance to the present invention.

### Detailed description of the invention

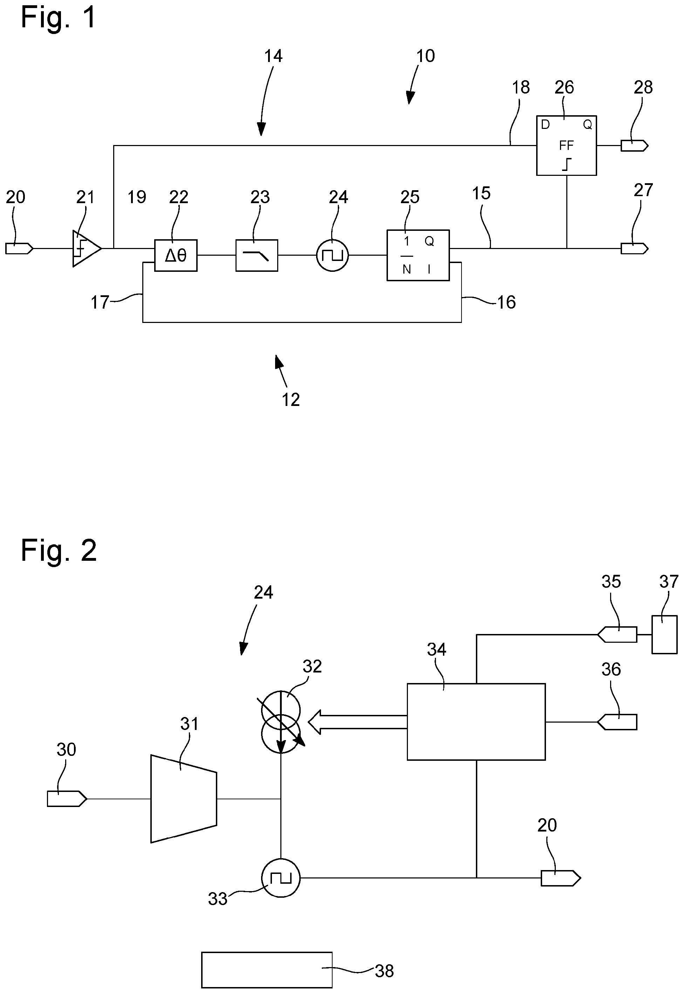

The BPSK demodulator 10 as shown in Fig. 1 comprises a signal branch 14 and a phase locked loop 12. The phase locked loop 12 comprises a digital phase detector 22, a loop filter 23, a voltage-controlled oscillator 24 and a frequency divider 25. The phase detector 22, the loop filter 23, the oscillator 24 and the frequency divider 25 are arranged in series. In other words, an output of the phase detector 22 is connected to an input of the loop filter 23. An output of the loop filter 23 is connected to an input of the voltage-controlled oscillator 24. An output of the voltage-controlled oscillator 24 is connected to an input of the frequency divider 25. The frequency divider 25 comprises an in-phase clock output 16, which is connected or coupled to a clock input 17 of the digital phase detector 22. Hence, the in-phase output 16 of the frequency divider 25 closes the phase locked loop 12. The frequency divider 25 further comprises a quadrature clock output 15, which provides a clock output 27 of the BPSK demodulator 10.

The demodulator 10 further comprises a signal input 20, which is configured to receive an input signal. The phase locked loop 12 is connected to the signal input 20 via a saturating amplifier 21. The saturating amplifier 21 may be implemented as a squaring amplifier. Accordingly, an oscillating input signal as provided by the signal input 20 can be transferred into a quasi-digital signal, hence into a square wave signal that is provided to an input 19 of the digital phase detector 22.

The output of the saturating amplifier 21 may be further coupled or connected to a sampling input 18 of a sampling flip-flop 26. The sampling flip-flop 26 may be connected to the saturating amplifier 21 via the signal branch 14. Hence, an output of the saturating amplifier 21 connected to the sampling input 18 of the sampling flip-flop 26 may form or constitute the signal branch 14.

The sampling flip-flop 26 may be implemented as a D flip-flop. The sampling flip-flop 26 may be triggered or clocked by the quadrature clock output 15 of the frequency divider 25 of the phase locked loop 12. Accordingly, the sampling flip-flop 26 comprises a data output 28 via which the demodulated data can be obtained or provided.

The internal structure of the voltage-controlled oscillator 24 is further illustrated in the block diagram of Fig. 2. The loop filter output 30 of the loop filter 23 may be connected to a voltage to current converter 31. The voltage-controlled oscillator 24 further comprises a ring oscillator 33, which is driven by the output of the voltage to current converter 31 and by an output of a bias digital to analog converter 32. The voltage to current converter 31 may be implemented as a transconductance amplifier and may transfer the voltage as obtained from the loop filter output 30 into a respective driving current.

Based on the driving current received by the ring oscillator 33 there will be provided an oscillating signal, which may provide a voltage-controlled oscillator clock. The voltage-controlled oscillator 24 further comprises a frequency estimator 34, which may be implemented as a digital assistance logic circuitry. The frequency estimator 34 is driven by a reference clock 36. It is further provided with trimming values 35 that may be obtained from a memory 37, e.g. implemented as a non-volatile memory 37. The entire BPSK demodulator 10 and/or the voltage-controlled oscillator 24 may be further controlled by a digital controller 38, which is only exemplary indicated in Fig. 2.

The frequency estimator 34 and/or the digital controller 38 are configured to conduct a multi-phase startup procedure of the BPSK demodulator 10 as described herein.

In a first startup phase and at each startup of the BPSK demodulator 10 the loop filter 23 is pre-charged to a DC level, which is defined by the trimming values 35 that are obtainable from the digital memory 37. The trimming values are initially set at a production test during or after manufacturing of the BPSK demodulator. The trimming values are chosen and selected to provide a bias voltage for the voltage-controlled oscillator 24 such that the oscillation of the voltage-controlled oscillator is at the target frequency of the BPSK demodulator 10 at room temperature. The respective voltage level and/or the associated trimming values are stored in the memory 37 and are applied at each startup of the voltage-controlled oscillator 24.

At the first phase of the demodulator startup the voltage-controlled oscillator 24 starts with an initial frequency, which is close to the carrier frequency of the input signal. A remaining or residual frequency offset may be only due to a temperature difference from room temperature. During this first startup phase the voltage-controlled oscillator 24 is kept in an idle state and does not oscillate, while the bias is propagated to make the oscillator ready for operation.

The digital frequency estimator 34 is configured to measure and/or to determine the frequency offset between the carrier frequency of the input signal and the startup frequency of the ring oscillator 33 and hence of the voltage-controlled oscillator 24. The digital frequency estimator 34 is further configured to adjust the startup frequency of the ring oscillator 33 and hence of the voltage-controlled oscillator 24 and to update the respective trimming values. During this the voltage-controlled oscillator 24 is let free running and the frequency offset, which might be due to temperature deviations from room temperature is reduced or even entirely annihilated by the frequency tuning as applied or provided by the digital frequency estimator.

In this way, a cycle slipping in the subsequent regular third startup phase or regular operation phase of the phase locked loop 12 can be effectively avoided. After the frequency offset has been cancelled or reduced to a minimum during the second startup phase, the demodulator is switched into the third startup phase, in which the phase locked loop 12 is closed by the digital controller 38 and the voltage controlled oscillator 24 is locked on the incoming carrier frequency and phase.

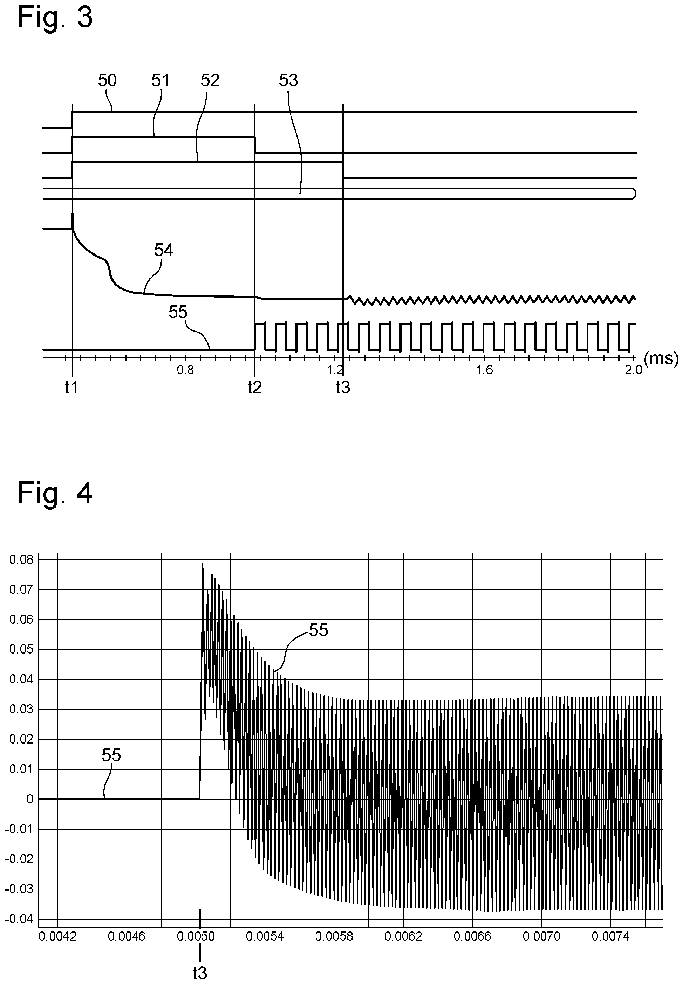

The switching between the three phases is particularly apparent from the diagram according to Fig. 3. There, the graph 50 represents an enable signal to operate the BPSK demodulator 10. The graph 51 shows the loop filter pre-charge signal, which is only present in the first startup phase, i.e. in a time interval between times t1 and t2. Graph 52 represents the startup phase of the BPSK demodulator and graph 53 represents the trimming applied on the voltage-controlled oscillator. Graph 54 is representative of a loop filter voltage applied during the subsequent phases of demodulator startup and graph 55 represents the output clock of the voltage-controlled oscillator.

During the first startup phase, i.e. in the time interval between times t1 and t2, the loop filter 23 is pre-charged thus leading to the settlement of the loop filter voltage to a final value, while the voltage-controlled oscillator 24 is and remains in an idle state. During this first phase of demodulator startup, the bias of the voltage-controlled oscillator 24 is set and hence propagated to make the voltage-controlled oscillator 24 ready for operation. In the second startup phase, i.e. in the time interval between t2 and t3 the voltage-controlled oscillator 24 is let free running while the digital frequency estimator 34 provides an estimation of the startup frequency of the voltage-controlled oscillator.

Here, at the end of the second phase of demodulator startup, the startup frequency of the voltage-controlled oscillator 24 is adjusted to reduce any frequency offset with respect to the carrier frequency of the input signal updating the trimming value, based on the results of the frequency estimator. At time t3 the demodulator is switched into the third startup phase, or into a regular mode of operation. Here, of the phase locked loop 12 is closed and the voltage-controlled oscillator 24 starts to oscillate at the startup frequency. The voltage-controlled oscillator 24 may be further locked on the phase and frequency of the input signal.

The transition from phase two into phase three is also apparent in greater detail in the diagram according to Fig. 4. As it is immediately apparent from the graph according to Fig. 4, by closing the loop at time t3 the loop filter voltage experiences a normal impulse response without any cycle slipping, and rather quickly adapts to a steady state where the phase of the loop is locked on the incoming signal phase to correctly demodulate the input signal.

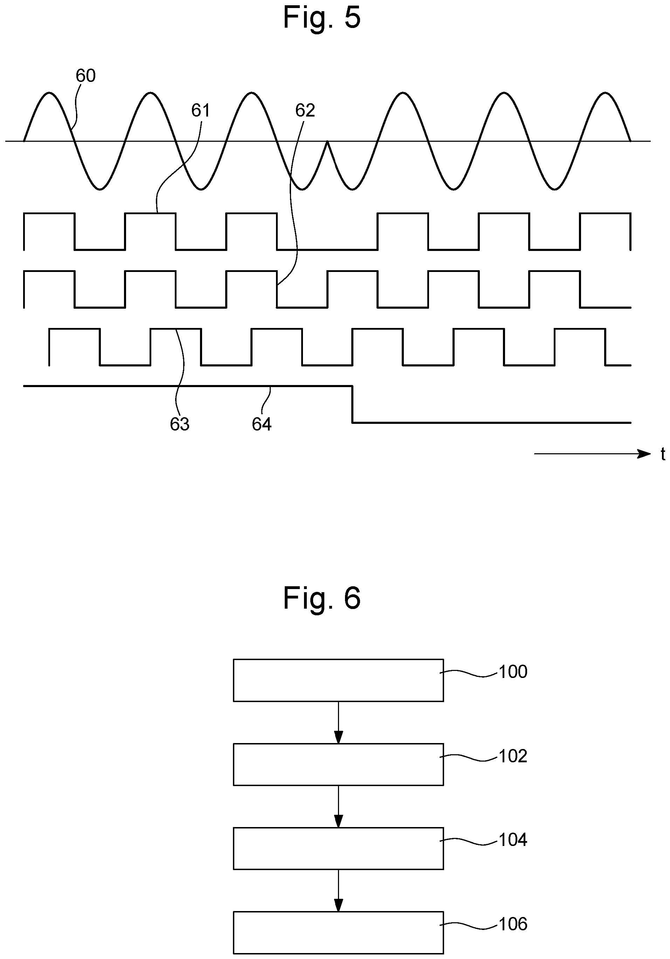

The modulation of the input signal is further apparent from Fig. 5. There, graph 60 represents the analog input signal. Graph 61 represents the output of the saturating amplifier 21. Graph 62 represents the in-phase clock output 16 of the frequency divider 25 of the phase locked loop 12. Graph 63 shows the quadrature clock output 15 of the frequency divider 25. Graph 64 finally represents the output of the sampling flip-flop 26 and hence the demodulated data output 28.

Sampling of the quasi-digital signal 61 is conducted and controlled by the quadrature clock signal 63. Since the quadrature clock signal 63 is 90° phase shifted relative to the in-phase clock signal 62, the sampling as provided by the flip-flop 26 always coincides with a maximum or minimum of the analog input signal, which inherently provides a comparatively large signal-to-noise ratio with a comparatively low bit error rate.

The flowchart according to Fig. 6 is illustrative of the individual method steps of demodulating the BPSK modulated input signal. In a first step 100 a BPSK demodulator 10 as described herein is used. In step 102 and during a first startup phase, the loop filter 23 is pre-charged on the basis of trimming values that are obtained from the digital memory 37. During this first startup phase the voltage-controlled oscillator 24 does not oscillate yet. In the subsequent step 104 the BPSK demodulator 10 is switched into the second startup phase, e.g., at time t2 in accordance with Fig. 3. Then, the voltage-controlled oscillator 24 is let free running for a limited time interval, e.g., until time t3 as indicated in Fig. 3.

During this second phase of demodulator startup, the voltage-controlled oscillator 24 is let free running while the phase locked loop 12 is not closed. During the second phase of demodulator startup the digital frequency estimator 34 provides an adjustment of the startup frequency of the voltage-controlled oscillator 24 and an update of the respective trimming values. Then, and in step 106 the demodulator 10 is switched into the third startup phase, in which the phase locked loop 12 is closed and in which the voltage-controlled oscillator 24 is locked on the incoming carrier frequency and phase.

The coherent BPSK demodulator 10 as described herein provides an excellent demodulation even with a minimum signal-to-noise ratio of the input signal. Moreover, the demodulator 10 qualifies by a comparatively low power consumption. The BPSK demodulator 10 as described herein provides a faster startup as well as a comparatively fast frequency and phase locking thanks to the use of the saturating or squaring amplifier and further due to the startup pre-charges amplifier and digitally assisted logic frequency compensation. This allows to regularly start the demodulator only when there is sufficient input signal energy available. Consequently, there is no need to keep the BPSK demodulator 10 always in an activated state. In conclusion, this helps to reduce the power consumption of the entire receiver chain.

Moreover, and compared to conventional phase locked loop designs the presently proposed demodulator requires less filters, and the digital level operating enables the use of low power and low area phase detectors, clock divider and I/Q clock generation as well as a comparatively low area data sampler, such as a sampling D flip-flop.

### Nomenclature

10. demodulator
12. phase locked loop
14. signal branch
15. quadrature clock output
16. in-phase clock output
17. clock input
18. sampling input
19. signal input
20. input
21. amplifier
22. phase detector
23. loop filter
24. voltage-controlled oscillator
25. frequency divider
26. sampling flip-flop
27. clock output
28. data output
30. loop filter output
31. voltage to current converter
32. bias current source
33. ring oscillator
34. frequency estimator
35. trim value
36. reference clock
37. memory
38. controller

## Claims

1. A coherent BPSK demodulator (10) comprising:
- an analog signal input (20) to provide an oscillating modulated input signal,
- a phase locked loop (12) comprising a phase detector (22), a loop filter (23), a voltage-controlled oscillator (24) and a frequency divider (25), which are connected in series, wherein in a first startup phase of the demodulator (10) the loop filter (23) is configured to become pre-charged in accordance with trimming values obtainable from a digital memory (37),
- a frequency estimator (34), which during a second startup phase of the demodulator (10) is operable to determine a frequency offset between a frequency of the input signal and a startup frequency of the voltage controlled oscillator (24), wherein the startup frequency is defined by the trimming values, and which is further operable to adjust the trimming values and the startup frequency to reduce the frequency offset.

2. The BPSK demodulator (10) according to claim 1, further comprising a digital controller (38), which is operable to lock the voltage-controlled oscillator (24) on the input signal in a third startup phase of the demodulator (10) after adjustment of the startup frequency.

3. The BPSK demodulator (10) according to claim 1 or 2, wherein the voltage-controlled oscillator (24) is configured to oscillate freely during the second startup phase of the demodulator (10).

4. The BPSK demodulator (10) according to any one of the preceding claims, wherein the phase locked loop (12) is unlocked during the second startup phase of the demodulator (10).

5. The BPSK demodulator (10) according to any one of the preceding claims, further comprising a saturating amplifier (21) between the analog signal input (20) and the phase locked loop (12).

6. The BPSK demodulator (10) according to any one of the preceding claims, wherein the phase locked loop (12) further comprises a digital phase detector (22) coupled to an input of the loop filter (23).

7. The BPSK demodulator (10) according to claim 6, wherein the frequency divider (25) comprises an in-phase clock output (16) coupled to a clock input (17) of the phase detector (22).

8. The BPSK demodulator (10) according to any one of the preceding claims, further comprising a sampling flip-flop (26) connected to the analog signal input (20) and triggered by a quadrature clock output (15) of the frequency divider (25).

9. The BPSK demodulator (10) according to claims 5 and 8, wherein the sampling flip-flop (26) comprises a sampling input (18) connected to an output of the saturating amplifier (21).

10. A method of demodulating a BPSK modulated signal comprising the steps of:
- using a BPSK demodulator (10) according to any one of the preceding claims,
- pre-charging the loop filter (23) on the basis of trimming values obtainable from a digital memory (37) during a first startup phase of the demodulator (10),
- deriving of a startup frequency of the voltage-controlled oscillator (24) on the basis of the trimming values,
- determining of a frequency offset between a frequency of the input signal and the startup frequency, and
- adjusting the trimming values and the startup frequency to reduce the frequency offset during a second startup phase of the demodulator (10).

11. The method according to claim 10, wherein after adjustment of the startup frequency and in a third startup phase of the demodulator (10), the voltage-controlled oscillator (24) is locked on the input signal and the phase locked loop (12) is closed.

12. The method according to claim 10 or 11, wherein the voltage-controlled oscillator (24) is let free running during the second startup phase of the demodulator (10).

13. The method according to any one of the preceding claims 10 to 12, wherein the phase locked loop (12) is driven or closed by an in-phase clock output (16) of the frequency divider (25).

14. The method according to any one of the preceding claims 10 to13, wherein the input signal is squarely amplified and provided to a sampling flip-flop (26).

15. The method according to claim 14, wherein the sampling flip-flop (26) is clocked by a quadrature clock output (15) of the frequency divider (25) of the phase locked loop (12).
